# EUROPEAN PATENT SPECIFICATION

(11) **EP 1 546 553 B1**
(45) Date of publication and mention of the grant of the patent: **09.08.2006**
(21) Application number: 03750628.4
(22) Date of filing: 25.09.2003
(51) Int. Cl.: F03D 11/00, H05K 7/20

(54) **DEHUMIDIFYING OF AIR WITHIN SWITCH CABINET FOR A WIND TURBINE BY MEANS OF PELTIER ELEMENT**
LUFTENTFEUCHTER FÜR WINDTURBINESCHALTSCHRANK MIT PELTIER-ELEMENT
DESHUMIDIFICATION DE L'AIR DANS UN BOITIER DE COMMUTATION POUR EOLIENNE AU MOYEN D'UN ELEMENT A EFFET PELTIER

(30) Priority: 27.09.2002 DE 10245103
(43) Date of publication of application: 29.06.2005
(73) Proprietor: GENERAL ELECTRIC COMPANY, Schenectady, NY 12345 (US)
(72) Inventor: ACHENBACH, Patrick, 48431 Rheine (DE)
(74) Representative: Goode, Ian Roy
(86) International application number: PCT/EP2003/010674
(87) International publication number: WO 2004/029450

(56) References cited:
- WO-A-01/21956
- WO-A-02/086313
- DE-A- 4 228 521
- DE-A- 10 139 556
- DE-A- 10 218 115
- DE-A- 19 621 485

## Description

### Field of the Invention

The present invention relates to a switch cabinet for a wind turbine with at least one circuit element accomodated in said switch cabinet and a drying arrangement for preventing water deposition onto said at least one circuit element as well as to a method for operating a wind turbine (see WO-A-01 021 956) using such a switch cabinet.

### Background of the Invention

The operating parameters of modem wind turbines, like e.g. blade angle, total orientation of the rotor and/or adjustments of the generator used for power generation, are electronically controlled. The electric or electronic circuit elements utilized therefor are usually accomodated in a switch cabinet mounted to the machine nacelle, which is disposed in a height of up to 100 m. This switch cabinet is subject to atmospheric influences. To guarantee reliable operation of the wind turbine, water should not be deposited onto the electric or electronic circuit elements during any atmospheric condition.

In prior art switch cabinets for wind turbines, this condition is ensured by heating the air in the switch cabinet to thereby prevent that the circuit boards accomodated in the switch cabinet cool down below the dew point. However, this measure is associated with high power consumption so that the profitability of wind turbine operation is significantly derogated. According to an alternative concept, desiccants are used for reducing the air humidity in the switch cabinet. However, the intake capacity of such desiccants is limited so that they need to be replaced frequently, which poses problems particularly when the switch cabinet is disposed at a height of 100 m or more. Furthermore, the reaction rate of desiccants for binding of air humidity is relatively low so that reliable prevention of water depositions onto the circuit elements cannot be achieved by this method. vide an improved switch cabinet for a wind turbine, particularly a switch cabinet which allows for reliable operation of the wind turbine without excessive power consumption, as well as a method for operating a wind turbine using this switch cabinet.

### Summary of the Invention

Due to an aspect of the present invention, this object is solved by an advancement of the prior art switch boards which is mainly characterized in that the drying arrangement includes a device for generating air flow in the region of the at least one circuit element.

Surprisingly, it was found that generating an air flow contributes to the prevention of water deposition onto circuit elements. This air flow can be generated with comparatively small power consumption by using a simple fan. A further improvement of operational reliability can be achieved when the drying arrangement further includes at least one heater for heating the air in the region of the at least one circuit element, because then the water vapor absorption capacity of the air is increased in the region of the at least one circuit element and, thus, the risk of condensation on the circuit element is reduced.

According to a preferred embodiment of the switch cabinet according to the present invention, the drying arrangement includes a cooling element for separating water from the passing air, said cooling element being spaced from said at least one circuit element, and a drain element for draining the separated water out of the switch cabinet. Thus, the air humidity within the switch cabinet is effectively reduced so that the risk of water deposition onto the at least one circuit element is counteracted. Thereby, the reduction of air humidity within the switch cabinet can be achieved in a particularly effective manner when the flow generating device is operable to generate an air flow, which circulates within said switch board and moves past the at least one circuit element as well as said cooling element, so that the air circulating within the switch board continously absorbs humidity which is then separated at the cooling element and is drained out of the switch cabinet through a drain opening. Peltier element mounted in the switch cabinet. In this typical embodiment of the present invention, an effective circulation of the air flow can be caused when the flow generating device includes a plate-like flow guidance element which is interspersed by the Peltier element, wherein the at least one circuit element is disposed at that side of the flow guidance element that faces the part of the Peltier element that is warmer during operation. Different atmospheric conditions can be accounted for when a control device is provided which controls the drying arrangement depending on temperature and/or air humidity within and/or outside the switch cabinet.

As can be also seen from the above explanation of a switch cabinet according to the present invention, a method for operating a wind turbine is provided, wherein at least one operating parameter of the wind turbine is controlled by at least one circuit element accomodated in a switch cabinet and deposition of condensation water onto the at least one circuit element is counteracted, said method being basically characterized in that an air flow in the region of the at least one circuit element is generated for preventing the deposition of water onto the at least one circuit element, wherein the air can be heated in the region of the at least one circuit element. In a typical embodiment of the method according to the present invention, condensation water is separated at a cooling element, which is spaced from the circuit element, and is drained out of the switch cabinet. Although passive cooling elements are also within the scope of the present invention, it was found to be particularly practical to use a Peltier element as an active cooling element while simultaneously heating the air in the region of the at least one circuit element, wherein the generation of the air flow and/or the activation of the cooling element can be controlled depending on temperature and/or air humidity within and/or outside the switch cabinet.

### Brief Description of Drawings

A full and enabling disclosure of the present invention, including the best mode thereof, to one of ordinary skill in the art, is set forth more particularly in the remainder of the specification, including reference to the accompanying figures wherein:
- Fig. 1: shows a schematic drawing of a switch cabinet according to a first ambodiment of the present invention.
- Fig. 2: shows a schematic drawing of a switch cabinet according to a second embodiment of the present invention.

### Detailed Description

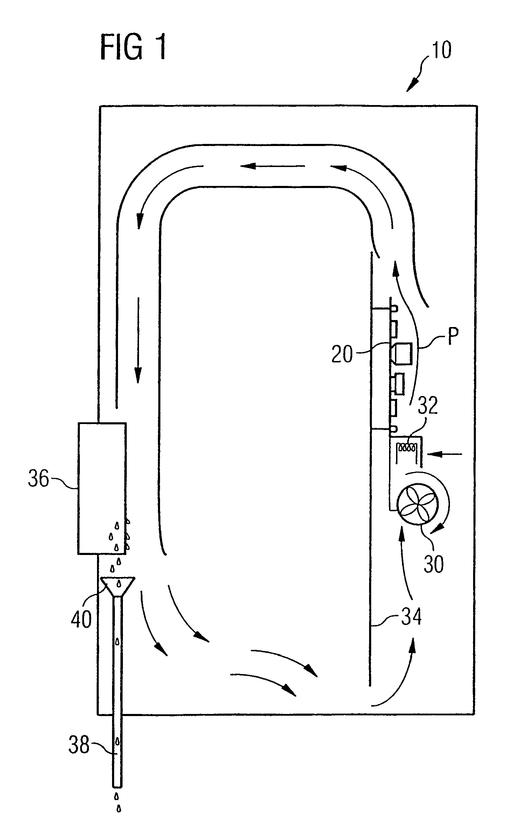

According to Fig. 1, a switch cabinet for a wind turbine according to a first embodiment of the present invention can be realized as a fully enclosed switch cabinet having a cabinet door which is closed during operation. A number of electric and/or electronic circuit elements is situated within the switch cabinet, wherein said circuit elements can be disposed on one or more circuit boards 20 as is exemplarily shown in Fig. 1. Furthermore, a drying arrangement is also accomodated in switch cabinet 10, wherein, according to the embodiment of the present invention shown in Fig. 1, said drying arrangement includes a fan 30 disposed below the circuit board, a heater 32 disposed upstream with respect to the air flow generated by said fan 30 and behind the fan 30, a flow guide plate 34 serving as a support for circuit board 20, and a cooling element 36 disposed upstream said circuit board and at that side of the flow guide plate 34 that does not face the circuit board.

An air flow directed towards the circuit board 20 is generated by the fan 30, which is disposed in close proximity to the circuit board below thereof, and on that side of the flow guide plate 34 that faces the circuit board, wherein the air flow is heated by means of a heater 32 implemented as a heating coil so that the heated air can absorb a large amount of air humidity and no condensation of air humidity occurs on the circuit board. After moving past circuit board 20, the air flow is deflected within switch cabinet 10 and then moves past cooling element 36 which is disposed on the side of flow guide plate 34 not facing circuit board 20.

In the embodiment according the present invention shown in Fig. 1, cooling element 36 is implemented as a passive cooling element and consists basically of a body made of heat conducting material, e.g. copper or aluminum, which is in contact with the ambient air outside of humidity contained in the passing air occurs if the ambient temperature drops to a value blow the dew point, i.e. to a vlaue of about 5°C or below. The water separated at the cooling element 36 is drained out of the switch cabinet 10 by means of a drain conduit 38, wherein the condensation water is collected by a hopper 40 disposed at the upper end of the drain conduit 38.

The drying arrangement shown in Fig. 1 is appropriately controlled by a corresponding control device, which can also be accomodated in switch cabinet 10, so that the operation of fan 30 and heater 32 are not started until the ambient temperature has dropped to a value of 5°C or below and/or the air humidity within and/or outside the switch cabinet exceeds a value of 80%. The operation of the drying arrangement may be stopped when the air humidity attained a value of less than 70%. Compared to prior art drying arrangements, which required heating of the total internal space of the switch cabinet to prevent condensation of water on the circuit elements, the switch cabinet 10 shown in Fig. 1 can be operated with less power consumption, because heating is required only in the region of the circuit board and, simultaneously, continous drying of the switch cabinet by condensation of air humidity at the cooling element 36 and draining of the condensation water by means of the drain conduit 38 is caused by the air circulating within switch cabinet 10 and moving past cooling element 36.

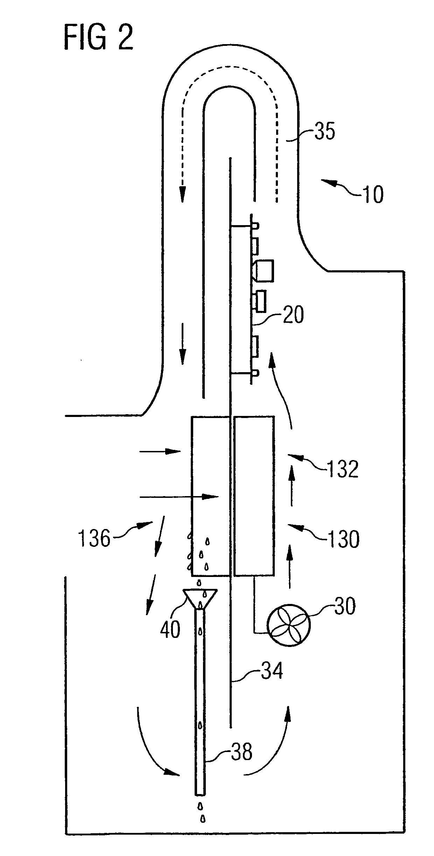

The second embodiment according to the present invention shown in Fig. 2 differs from the embodiment shown in Fig. 1 mainly in that a heater in the form of a Peltier element 130 is used instead of the heater in the form of a heating coil. The Peltier element 130 is arranged so that its warmer side 132, in an operating condition, is disposed on the same side of flow guide plate 34 as circuit board 20. The air heated by the warmer side 132 of Peltier element 130 moves past circuit board 20 and is deflected by a flow conduit 35 so that it moves past the cooler side 136, in an operating condition, of Peltier element 130 at the side of flow guide plate 34 not facing circuit board 20. Thereby, the Peltier element is used as an active cooling element, wherein the water contained in the air circulating within the switch cabinet condenses at its cooler side and is collected by means of a hopper 40 and is subsequently drained out of the switch cabinet via a drain conduit 38. The arrangement shown in Fig. 2 allows the drying of the air contained in the switch cabinet even at ambient temperature when the air humidity within the switch cabinet exceeds a predetermined limit value of, e.g., 80%. Peltier element 130 and fan 30 may be automatically stopped by a respective control device when the air humidity attains a value of 70% or less. Also, a combination of temperature and air humidity measurements are possible for controlling the operation of the drying arrangement.

Having thus described the invention in detail, it should be apparent that various modifications can be made in the present invention without departing from the scope of the following claims.

## Claims

1. A switch cabinet (10) for a wind turbine with at least one circuit element (20) accomodated in said switch cabinet (10) and a drying arrangement for preventing a water deposition onto the at least one circuit element (20),
**characterized in that**
the drying arrangement comprises a device (30) for generating an air flow in a region of the at least one circuit element (20).

2. The switch cabinet (10) according to claim 1, **characterized in that** the drying arrangement comprises at least one heating device (32; 132) for heating the air in the neighborhood of the at least one circuit element (20).

3. The switch cabinet (10) according to claim 1 or 2, **characterized in that** the drying arrangement comprises a cooling element (36; 136) for separating water from air flowing by, said cooling element being spaced from said at least one circuit element (20), as well as at least one drain element (38, 40) for draining the separated water out of the switch cabinet (10).

4. The switch cabinet (10) according to claim 3, **characterized in that** the flow generating device (30) is operable for generating an air flow, which circulates within said switch cabinet (10) and thereby moves past the at least one circuit element (20) and the cooling element (36; 136).

5. The switch cabinet (10) according to claim 3 or 4, **characterized in that** the heating device (132) and the cooling element (136) comprise a Peltier element (130).

6. The switch cabinet (10) according to claim 5, **characterized in that** the flow generating device (30) comprises a plate-like flow guidance element (34) interspersed with said Peltier element (130), wherein the at least one circuit element (20) is disposed at a side of the flow guidance element (34) facing the warmer part of the Peltier element (130)

7. The switch cabinet (10) according to any of the preceding claims, **characterized by** a control device which controls the drying arrangement depending on temperature and/or air humidity within and/or outside said switch cabinet (10).

8. A method for operating a wind turbine, wherein at least one operational parameter of the wind turbine is controlled by at least one circuit element (20) accomodated in a switch cabinet (10) and wherein the deposition of condensation water onto said at least one circuit element (20) is counteracted, **characterized in that** an air flow is generated in the internal space of the switch cabinet (10) in the region of the at least one circuit element (20) for preventing the deposition of water onto the at least one circuit element (20).

9. The method according to claim 8, **characterized in that** the air in the region of the at least one circuit element (20) is heated.

10. The method according to claim 8 or 9, **characterized in that** condensation water is separated at a cooling element (36; 136) spaced from said at least one circuit element (20) and is drained out of the switch cabinet (10).

11. The method according to claim 9 or 10, **characterized in that** the air is heated by a Peltier element (130) which is also used as a cooling element (36; 136).

12. The method according to any of claims 8 to 11, **characterized in that** the generation of the air flow, the heating of the air and/or the activation of the cooling element (36; 136) is controlled depending on temperature and/or air humidity within and/or outside the switch cabinet.

## Patentansprüche

1. Schaltschrank (10) für eine Windturbine mit wenigstens einem in dem Schaltschrank (10) untergebrachten Schaltungselement (20) und einer Trocknungsanordnung, um eine Wasserabscheidung auf dem wenigstens einen Schaltungselement (20) zu verhindern,
**dadurch gekennzeichnet, dass**
die Trocknungsanordnung eine Vorrichtung (30) zum Erzeugen eines Luftstroms in dem Bereich des wenigstens einen Schaltungselementes (20) aufweist.

2. Schaltschrank (10) nach Anspruch 1, **dadurch gekennzeichnet, dass** die Trocknungsanordnung wenigstens eine Heizvorrichtung (32; 132) zum Erwärmen der Luft in der Nachbarschaft des wenigstens einen Schaltungselementes (20) aufweist.

3. Schaltschrank (10) nach Anspruch 1 oder 2, **dadurch gekennzeichnet, dass** die Trocknungsanordnung ein Kühlelement (36', 136'), um Wasser aus vorbeiströmender Luft abzutrennen, wobei das Kühlelement von dem wenigstens einen Heizelement (20) in Abstand angeordnet ist, sowie wenigstens ein Ableitelement (38, 40) aufweist, um das abgetrennte Wasser aus dem Schaltschrank (10) abzuleiten.

4. Schaltschrank (10) nach Anspruch 3, **dadurch gekennzeichnet, dass** die Strömungs-Erzeugungsvorrichtung (30) zur Erzeugung eines Luftstromes betreibbar ist, welcher innerhalb des Schaltschrankes (10) zirkuliert und sich dadurch an dem wenigstens einen Schaltungselement (20) und dem Kühlelement (36; 136) vorbeibewegt.

5. Schaltschrank (10) nach Anspruch 3 oder 4, **dadurch gekennzeichnet, dass** die Heizvorrichtung (132) und die Kühlvorrichtung (136) aus einem Peltier-Element (130) bestehen.

6. Schaltschrank (10) nach Anspruch 5, **dadurch gekennzeichnet, dass** die Strömungserzeugungsvorrichtung (30) ein plattenartiges Strömungsführungselement (34) aufweist, das zwischen das Peltier-Element (130) eingeschoben ist, wobei das wenigstens eine Schaltungselement (20) auf einer Seite des Strömungsführungselementes (34) angeordnet ist, die dem wärmeren Teil des Peltier-Elementes (130) gegenüberliegt.

7. Schaltschrank (10) nach einem der vorstehenden Ansprüche, **gekennzeichnet durch** eine Steuervorrichtung, welche die Trocknungsanordnung abhängig von der Temperatur und/oder Luftfeuchtigkeit innerhalb und/oder außerhalb des Schaltschrankes (10) steuert.

8. Verfahren zum Betreiben einer Windturbine, wobei wenigstens ein Betriebsparameter der Windturbine durch wenigstens ein in einem Schaltschrank (10) untergebrachtes Schaltungselement (20) gesteuert wird, und wobei der Abscheidung von Kondensationswasser auf dem wenigstens einen Schaltkreis (20) entgegengewirkt wird, **dadurch gekennzeichnet, dass** ein Luftstrom in dem Innenraum des Schaltschrankes (10) in dem Bereich des wenigstens einen Schaltungselementes (20) erzeugt wird, um die Abscheidung von Wasser auf dem wenigstens einen Schaltungselement (20) zu verhindern.

9. Verfahren nach Anspruch 8, **dadurch gekennzeichnet, dass** die Luft in dem Bereich des wenigstens einen Schaltungselementes (20) erwärmt wird.

10. Verfahren nach Anspruch 8 oder 9, **dadurch gekennzeichnet, dass** das Kondensationswasser bei einem von dem wenigstens einen Schaltungselement (20) in Abstand angeordneten Kühlelement (36; 136) entfernt und aus dem Schaltschrank (10) abgeleitet wird.

11. Verfahren nach Anspruch 9 oder 10, **dadurch gekennzeichnet, dass** die Luft durch ein Peltier-Element (130) erwärmt wird, welches auch als ein Kühlelement (36; 136) verwendet wird.

12. Verfahren nach einem der Ansprüche 8 bis 11, **dadurch gekennzeichnet, dass** die Erzeugung des Luftstroms, die Erwärmung der Luft und/oder die Aktivierung des Kühlelementes (36; 136) abhängig von der Temperatur und/oder der Luftfeuchtigkeit innerhalb und/oder außerhalb des Schaltschrankes gesteuert wird.

## Revendications

1. Boîtier de commutation (10) pour éolienne comportant au moins un élément de circuit (20) logé dans ledit boîtier de commutation (10) et un agencement de séchage destiné à empêcher que de l'eau se dépose sur l'élément de circuit (20) au minimum unique,
**caractérisé en ce que**
l'agencement de séchage comprend un dispositif (30) destiné à générer un écoulement d'air sur la zone de l'élément de circuit (20) au minimum unique.

2. Boîtier de commutation (10) selon la revendication 1, **caractérisé en ce que** l'agencement de séchage comprend au moins un dispositif de chauffage (32 ; 132) destiné à chauffer l'air au voisinage de l'élément de circuit (20) au minimum unique.

3. Boîtier de commutation (10) selon la revendication 1 ou 2, **caractérisé en ce que** l'agencement de séchage comprend un élément de refroidissement (36 ; 136) destiné à séparer l'eau de l'air environnant qui s'écoule, ledit élément de refroidissement étant espacé dudit élément de circuit (20) au minimum unique, ainsi qu'au moins un élément d'écoulement (38, 40) destiné à l'écoulement, hors du boîtier de commutation (10), de l'eau qui a été séparée.

4. Boîtier de commutation (10) selon la revendication 3, **caractérisé en ce que** le dispositif (30) de génération d'écoulement peut être mis en fonctionnement pour générer un écoulement d'air, qui circule à l'intérieur dudit boîtier de commutation (10) et qui, de ce fait, se déplace en passant devant l'élément de circuit (20) au minimum unique et devant l'élément de refroidissement (36 ; 136).

5. Boîtier de commutation (10) selon la revendication 3 ou 4, **caractérisé en ce que** le dispositif de chauffage (132) et le dispositif de refroidissement (136) comprennent un élément du type Peltier (130).

6. Boîtier de commutation (10) selon la revendication 5, **caractérisé en ce que** le dispositif (30) de génération d'écoulement comprend un élément de guidage d'écoulement en forme de plaque (34) associé audit élément du type Peltier (130), l'élément de circuit (20) au minimum unique étant disposé sur un côté de l'élément de guidage d'écoulement (34) situé face à la partie chaude de l'élément du type Peltier (130).

7. Boîtier de commutation (10) selon l'une quelconque des revendications qui précèdent, **caractérisé en ce qu'**il comprend un dispositif de commande qui commande l'agencement de séchage en fonction de la température et/ou de l'humidité de l'air à l'intérieur et/ou à l'extérieur dudit boîtier de commutation (10).

8. Procédé de mise en fonctionnement d'une éolienne, dans lequel au moins un des paramètres de fonctionnement de l'éolienne est commandé par au moins un élément de circuit (20) logé dans un boîtier de commutation (10) et dans lequel le dépôt d'eau de condensation sur ledit élément de circuit (20) au minimum unique est empêché, **caractérisé en ce qu'**un écoulement d'air est généré dans l'espace interne du boîtier de commutation (10) dans la zone de l'élément de circuit (20) au minimum unique, pour empêcher le dépôt d'eau sur l'élément de circuit (20) au minimum unique.

9. Procédé selon la revendication 8, **caractérisé en ce que** l'air présent dans la zone de l'élément (20) au minimum unique est chauffé.

10. Procédé selon la revendication 8 ou 9, **caractérisé en ce que** de l'eau de condensation est séparée au niveau d'un élément de refroidissement (36 ; 136) espacé dudit élément de circuit (20) au minimum unique et est évacuée hors du boîtier de commutation (10).

11. Procédé selon la revendication 9 ou 10, **caractérisé en ce que** l'air est chauffé par un élément du type Peltier (130) qui est également utilisé en tant qu'élément de refroidissement (36,136).

12. Procédé selon l'une quelconque des revendications 8 à 11, **caractérisé en ce que** la génération de l'écoulement d'air, le chauffage de l'air et/ou l'activation de l'élément de refroidissement (36 ; 136) sont commandés en fonction de la température et/ou de l'humidité de l'air à l'intérieur et/ou à l'extérieur du boîtier de commutation.
